(19) **Europäisches Patentamt European Patent Office Office européen des brevets**

(11) **EP 3 055 903 B1**

(12) **EUROPEAN PATENT SPECIFICATION**

(45) Date of publication and mention of the grant of the patent:
**13.05.2020 Bulletin 2020/20**

(21) Application number: **14781563.3**

(22) Date of filing: **08.10.2014**

(51) Int Cl.:
**H01Q 17/00** *(2006.01)* **H05K 9/00** *(2006.01)*

(86) International application number:
**PCT/EP2014/071572**

(87) International publication number:
**WO 2015/052254 (16.04.2015 Gazette 2015/15)**

(54) **ELECTROMAGNETIC FIELD ABSORBING COMPOSITION**

ELEKTROMAGNETISCHES FELD ABSORBIERENDE ZUSAMMENSETZUNG

COMPOSITION ABSORBANT LES CHAMPS ÉLECTROMAGNÉTIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.10.2013 GB 201318025**

(43) Date of publication of application:
**17.08.2016 Bulletin 2016/33**

(73) Proprietor: **Qinetiq Limited Farnborough, Hampshire GU14 0LX (GB)**

(72) Inventors:
• **FIXTER, Greg Peter Wade Malvern Worcestershire WR14 3PS (GB)**

• **HUSSAIN, Shahid Malvern Worcestershire WR14 3PS (GB)**
• **PATERSON, Alexandra Frances Malvern Worcestershire WR14 3PS (GB)**

(74) Representative: **QINETIQ IP QinetiQ Limited Intellectual Property Malvern Technology Centre St Andrews Road Malvern, Worcestershire, WR14 3PS (GB)**

(56) References cited:
**WO-A1-03/098989 WO-A1-2010/109174 US-A1- 2009 226 673 US-B1- 7 897 882**

**Description**

This invention relates to the field of an electromagnetic (EM) field absorbing composition, in particular a composition capable of providing absorbance in the frequency of commercial radar. The composition finds particular use as a radar absorbing coating for wind turbines. There are further provided coated surfaces comprising the composition, methods of absorbing EM radiation, and methods of use of such a composition.

Wind turbines interfere with radar systems, leading to errors in the detection of other objects. Radar systems work by sending out pulses of electromagnetic energy, which are reflected back from the objects that controllers wish to detect, such as the location of an aircraft. The controller must distinguish the objects from the clutter i.e. unwanted returns, such as reflections from wind turbines and buildings, as well as other background noise. Therefore, reducing the reflected energy from wind turbine towers may reduce their adverse impact on radar systems and lead to an increase in their use.

WO 2010/109174 discloses an electromagnetic (EM) field absorbing composition capable of providing absorbance in the frequency of commercial radar, the composition comprising elongate carbon elements with an average longest dimension in the range of 50 to 1000 microns, and with a thickness in the range of 1 to 15 microns, present in the range of 0.5 to 20 volume%.

US 7,897,882 discloses a multilayered EMI/RF absorbing film comprising a polymer resin with metallic flakes dispersed therein. The EMI/RF film is effective for absorbing electromagnetic waves having a frequency of about 10 MHz to about 40 GHz. The film comprises up to about 40 wt% or more of metallic flake, and the specific example of US 7,897,882 is a four layer film produced from a low solids layer comprising more than 25 weight percent total coated and uncoated permalloy flake, and three high solids layers individually comprising more than 43 weight percent total coated and uncoated permalloy flake. The multilayered film of US 7,897,882 is a thin film having a thickness of 13 to 15 mils, and is acceptable for shielding electronic components. However, although the multilayer film is likely to exhibit a certain amount of RF absorption, the high permalloy loading of the examples makes it unsuitable for use as a coating in a tuned radar absorbing structure.

Further absorbing compositions are known from WO 03/098989 and US 2009/226673.

The object of the invention is to provide an improved coating composition for use as a radar absorbing material (RAM) and/or in a radar absorbing structure.

According to a first aspect of the invention, defined by the appended claims, there is provided an electromagnetic radiation absorbing composition comprising a magnetic filler material taking the form of a metallic flake, and a non-conductive binder, wherein the magnetic filler is present in the range of from 1 to 5 volume% of dried volume.

The absorbing compositions of the invention are narrowband absorbers, typically less than 1 GHz in bandwidth. Hence the absorber compositions are suitable for use with commercial radars, but are generally unsuitable for use in military applications (which require broadband radar absorption).

It is known from WO 2010/109174 to use a relatively low loading of carbon fibres to provide a narrowband electromagnetic field absorbing composition. However, the inventors have found that absorbing compositions according to WO 2010/109174 can exhibit poor tolerance and reproducibility when used in thin absorbing structures. This is because their particularly narrow bandwidth makes the composition susceptible to minor changes in coating thickness and/or batch-to-batch variations in the absorbing composition.

There is a general tendency to avoid traditional magnetic fillers in lightweight coatings for wind turbine applications because magnetic fillers are denser than carbon-based fillers, and are conventionally required at higher loadings (leading to percolation effects). Moreover, the broader low amplitude bandwidth of magnetic fillers is generally regarded as undesirable.

The inventors have nevertheless found that the absorption properties of magnetic filler materials can be suitable for EM absorbing (preferably radar absorbing) applications, provided that strict selection criteria as defined in the appended claims are observed. Specifically, in the invention defined only by the appended claims the magnetic filler material takes the form of a metallic flake, and is provided in an amount in the range of 1 to 5 volume% of dried volume. More preferably, the magnetic filler is present in the range of from 2 to 5 volume% of dried volume, even more preferably the magnetic filler is present in the range of from 2 to 3.5 volume% of dried volume and most preferably, the magnetic filler is present in the range of from 2.25 to 2.5 volume% of dried volume.

Advantageously, coating compositions according to the invention still provide narrowband absorption, but at an increased bandwidth. This significantly improves manufacturing and coating tolerances compared to prior art carbon fibre dielectric fillers, particularly at lower coating and/or absorber structure thicknesses.

The invention uses flaked fillers. Flaked particles possess a large exposed surface area and hence, exhibit a strong coupling effect. This leads to useful dielectric properties (high polarisability) and improved magnetic properties (increased magnetisability) when compared with most other particle geometries. As a result, flaked magnetic filler materials exhibit favourable properties with regard to mass and electromagnetic considerations.

In the invention, a specially selected and narrow volume % range of flaked magnetic filler is used, and it is important that the amount of metallic flake is carefully controlled so as to avoid disadvantageous effects. The magnetic properties of a coating of dried composition according to the invention are dependent upon the microstructure formed within said coating. High concentrations of metal flake within the coating such as, for example, concentrations in excess of about 5 vol%, more preferably in excess of about 3.5 vol%, tend to lead to an increase in the permittivity, causing conduction pathways and percolation effects. At that point, resonant cancellation can no longer be used in a RAM structure. Moreover, a higher loading increases cost. Conversely, if the amount of filler material is lower than 1 vol%, more preferably lower than 2 vol%, the absorption bandwidth decreases below the desired tolerance levels.

The chemical composition of the metallic flake is selected to provide a desired position of maximum magnetic loss for a particular application, for example to enable a tuned structure to have an absorption maximum at about 3 GHz or about 9.6 GHz. Suitable magnetic filler materials include ferrites (such as, for example, magnetite), nickel and iron nickel alloys. The filler material used in the present invention is permalloy flake, which typically exhibits ferromagnetic resonance at low frequencies (<5 GHz) dependent upon the relative iron to nickel ratio. Permalloy flake is used to provide an absorber composition with a peak absorption frequency at approximately 3 GHz, which is desirable for commercial applications. Permalloy is a magnetic alloy comprising nickel and iron, which has an advantageously high magnetic permeability. The permalloy flake may have any suitable ratio of nickel to iron, the Ni:Fe ratio being selected to optimise both the amplitude and position (frequency) of the ferromagnetic resonance response. One preferred permalloy composition comprises about 20% iron and about 80% nickel ($Fe_{0.2}Ni_{0.8}$), and another possible composition is about 45% nickel and about 55% iron ($Fe_{0.55}Ni_{0.45}$). Permalloy may comprise other metals, for example molybdenum. Examples of molybdenum-containing permalloy compositions are 81% nickel, 17% iron and 2% molybdenum, and 79% Ni, 16% Fe and 5% Mo. In the invention as defined by independent claim 2, the permalloy is 81% nickel, 17% iron and 2% molybdenum.

The volume percentages defined herein are defined as a volume percentage of the final dried composition (i.e. without solvent). However, in order to facilitate the composition being deposited or applied in the form of a coating (which may comprise one, or more than one, layer) a solvent may be present. It may be desirable to add sufficient solvent such that the composition may be applied to achieve the required final dried coating thickness in order to absorb at the frequency of the incident radiation. The composition may comprise a liquid formulation prior to application, and is preferably in the form of a dried coating after its application.

A coating of dried composition according to the invention is particularly suitable for providing a radar absorbing coating for wind turbines. The composition when applied to a surface, such as a wind turbine tower, at a selected thickness may reduce radar reflections. The reduction of these reflections reduces the structure's impact on the operation of nearby air traffic control, air defence, meteorological and marine navigational radars. The composition according to the invention finds particular use for absorbing known radar frequencies from known local sources. As a result, renewable energy systems, such as wind farms, may be more readily located near existing radar installations.

The electromagnetic requirements of radar absorbing materials are well-established. The first requirement is to maximise the electromagnetic radiation entering the structure, by minimising front-face reflection. This is achieved if the real and imaginary components of the complex permittivity, $\varepsilon$, and permeability, $\mu$, are equal, as derived from the perfect impedance match condition. The second requirement is that the signal is sufficiently attenuated once the radiation has entered the material. This condition is met for high values of imaginary permittivity and permeability, which by definition provide the contribution to dielectric and magnetic loss, respectively. RAM performance can be optimised by its incorporation into a number of different structures, for example a Dallenbach absorber (or a graded impedance absorber for multiple layers), or a Salisbury Screen absorber (or a Jaumann absorber for multiple layers).

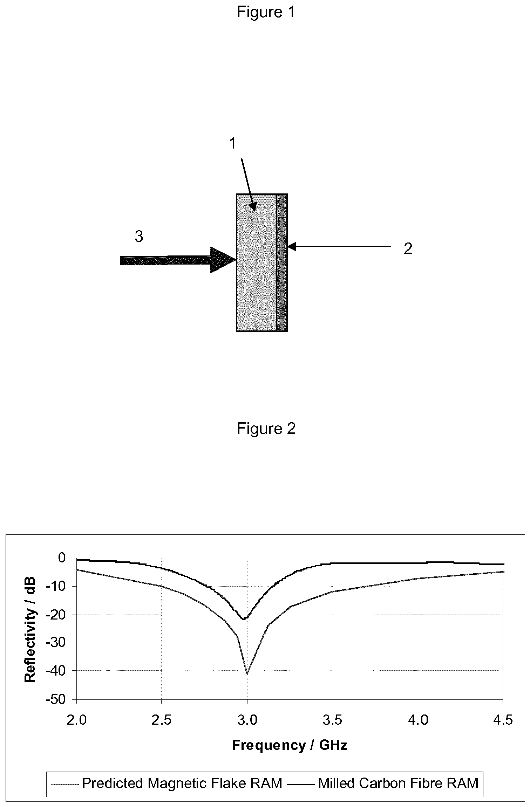

The incorporation of magnetic fillers into host matrices generally relates to Dallenbach (or graded impedance) absorbers. A typical Dallenbach absorber (see Figure 1) comprises an absorbing layer with a metallic backing, and is characterised by resonant absorption at one or more discrete frequencies. In the invention, the coating is preferably used as, or comprises part of, the absorbing layer of a Dallenbach or graded impedance absorber.

Prior art metal flake-based coatings for EM shielding applications, as exemplified by US 7,897,882, generally have low levels of EM absorption compared to the invention, because a shielding material is fundamentally reflective. To achieve this requires percolation, which is typically achieved by forming conductive networks from high flake loading and/or high flake aspect ratios. In the invention, high width to length flake aspects ratios are preferably avoided, so as to achieve a fundamentally different alignment of flaked particles and hence, absorption rather than reflection. In other words, the properties of the metallic flake in the invention are preferably specially selected to avoid percolation effects.

Preferably, the metallic flake has an average flake size that lies in the range 1 to 100 microns, more preferably in the range of 10 to 50 microns (assuming a normal distribution). Where processing methods give rise to other particle size distributions, not more than 25% by weight of the flakes should exceed 100 microns, preferably 50 microns. The metallic flake preferably has an average thickness of less than 4 microns and more preferably, the average thickness is in the range of from 0.1 to 3 microns, or even 0.5 to 2 microns. The metallic flake preferably takes the form of a regular or irregular disc, with an average width to length ratio less than 1:5, more preferably less than 1:2 and most preferably about 1:1. Advantageously, using a regular or irregular disc-like flake in the invention provides a coating that can be substantially orientation independent, i.e. the coating is isotropic at the maximum field absorption.

The composition according to the invention may comprise one or more additional components selected from high shear thickeners, low shear thickeners, and dispersion additives. A number of thickeners and solvents, such as, for example, those routinely used in paint formulations, may be added to the composition in order to improve the flow during application and improve its adherence to different surfaces.

The non-conductive binder may be selected from any commercially available binder. Preferably, the binder is selected from an acrylate binder (such as, for example, methyl methacrylate MMA), an acrylic binder, an epoxy binder, a urethane and/or epoxy-modified acrylic binder, a polyurethane binder, an alkyd based binder (which may be a modified alkyd), or a fluoropolymer based binder. The binder may be a two part polyurethane binder. Alternatively, the binder may be selected from a water-based dispersion comprising a binder selected from an acrylic, or polyurethane based latex. The binders, thickeners and dispersion agents routinely used in paint formulations are typically not volatile, so will not usually be lost during the curing i.e. drying process. In contrast to the binders, the solvent that is added to aid deposition or application may evaporate during the drying process.

The composition according to the invention may further comprise a paint pigment, which is typically present in the range of from 2 to 20 volume% of dried volume. The pigment may be present in a sufficient amount to provide colour to the composition without reducing the absorption properties of said composition. The paint pigment may be any opaque paint pigment, for example a metal oxides such as $TiO_2$. It may be desirable to add further pigments and/or dyes to the composition, so as to provide different coloured paints. Further pigments may include inorganic or organic pigments, for example metal oxides, phthalocyanines, or azo pigments. Optionally, calcium carbonate and/or talc may be added to the composition, to reduce cost and improve flow characteristics.

The composition according to the invention requires a magnetic filler material in the form of a metal flake. In some embodiments, the composition may further comprise a dielectric filler material, such as, for example, carbon fibres. In the embodiments according to independent claim 1, the dielectric filler material comprises milled carbon fibres. Magnetic filler materials in the form of a magnetic flake are typically more expensive than dielectric filler materials, so a hybrid magnetic-dielectric filler can provide a cheaper EM absorbing composition whilst still increasing the bandwidth of the absorber. Moreover, a hybrid composition can generally be applied at a lower coating thickness than a composition substantially based on a metal flake filler, which can be advantageous for some applications.

The composition is typically used as a coating on a surface or structure. The thickness of a coating of the dried composition of the invention is preferably selected to lie in the range of from $\lambda/3$ to $\lambda/5$ of the wavelength of the resonant frequency of the incident radiation, more preferably in the region of one quarter of the wavelength ($\lambda/4$) of the resonant frequency of the incident radiation.

More precisely the below relationship is observed in Formula (I):

$$\lambda = \frac{\lambda_0}{\sqrt{\varepsilon\mu}} \qquad \text{Formula I}$$

wherein A corresponds to the wavelength in the coating of dried composition, $\lambda_0$ is the free space wavelength and $\varepsilon$ and $\mu$ are the permittivity and permeability of the coating of dried composition according to the invention

Preferably, the thickness of the coating is selected such that absorption is obtained at a desired frequency/wavelength of incident radiation, for example around 3 GHz or around 9.4 GHz. It will, of course, be understood that these are mere examples of selected narrow frequency absorbers, and therefore the composition according to the invention is not limited to these frequencies. The composition may be deposited at other thicknesses in order to produce optimum performance at alternative frequencies. Typically, the thickness of the coating is in the order of millimetres for wind turbine applications.

In order to carefully control the thickness, the coating of composition may be cast in the form of an applique film which has been prepared under controlled conditions to the selected thickness. Alternatively, the composition may be applied directly to an existing structure, such as, for example, a wind turbine by known methods such as, for example spraying, rolling or brushing. In a preferred arrangement, the application is performed such that each successive layer is applied substantially orthogonally to the preceding layer. This provides an advantage that if during the manufacture or mixing of the formulation the metal flakes undergo any degree of alignment, then subsequent applications applied at orthogonal orientations will maximise absorbance in all polarisation orientations of incoming radiation.

The total filler content volume% may be different in each successive application layer, and may also be applied in an orthogonal orientation as hereinbefore defined.

Many structures and especially wind turbine towers either contain large amounts of metal or are constructed almost entirely out of metal, which leads to their interference with radar. Where the surface of said structure is metal the composition according to the invention may be applied directly to the metal surface, as the metal structure serves to provide a reflective backplane.

Where the surface, structure or body is not substantially constructed from metal, preferably there is provided an electromagnetic reflective backplane between the surface, structure or body and the at least one dried coating according to the invention. Therefore, where the outer surface of a structure, such as, for example, a wind turbine tower, is not substantially prepared from a metal and there is interference with nearby radar, it may be desirable to provide an EM reflective backplane, such as, for example, an EM reflective coating, a metal foil or electromagnetic (EM) shielding paint, directly on the surface of said tower, i.e. between the surface of the structure and the composition according to the invention. One such example of an EM shielding paint is the Applicant's WO 2009/095654.

The composition according to the invention may be over painted with a suitable decorative paint. Particular advantage is found when the uppermost layer of composition has a lower vol% of magnetic filler than the preceding layer. Preferably, the uppermost layer has substantially no magnetic filler, such as, for example, a commercial non EM absorbing paint. The non EM paint will have a lower permittivity and therefore provides a better impedance match to free space. This reduces the reflection of the radiation at the front face, allowing more to penetrate into the absorbing layer and to be absorbed.

The extent of the coverage of the dried composition on a surface, body or structure will depend on the extent of the reflective nature of the surface, body or structure. It will be clear to the skilled man that greater absorption will be achieved if the entire surface, body or structure is coated with the composition.

In another aspect there is provided a radar absorbing surface, structure or body, or portions thereof, comprising at least one dried coating according to the invention. In a preferred arrangement the thickness of said coating is one quarter of the wavelength ($\lambda$/4) of the resonant frequency of the incident radiation to be absorbed. An electromagnetic reflective backplane may be provided between the surface, structure or body, or portion thereof, and the at least one dried coating. Preferably, the dried coating forms an exposed topmost layer.

In another aspect there is provided an applique film comprising a composition according to the invention.

In another aspect there is provided a method of providing absorption of electromagnetic radiation at a selected frequency on a surface structure or body or portions thereof, comprising the step of determining the selected frequency, applying at least one coat of composition according to one aspect of the invention at a thickness which selectively absorbs at said frequency, or an applique film according to another aspect of the invention with a thickness which selectively absorbs at said frequency, to a first side of said surface structure or body or portions thereof, and optionally to a second side.

Generally, absorbance needs to occur only at the selected frequency of the nearby radar source. Typical radar systems operate at very precise frequencies, rather than a broad band. The frequencies typically lie in the range 0.1 to 20 GHz, preferably in the range 2 to 5 GHz, even more preferably in the range 2.5 to 3.5 GHz.

In another aspect there is provided the use of a composition according to the invention, wherein the composition is applied to a surface, structure or body or portions thereof at a selected thickness so as to provide a coating capable of absorbing electromagnetic radiation at a selected frequency. Preferably, the composition is applied as a paint composition. Conveniently, the composition attenuates electromagnetic radiation in the frequency range 0.1 to 20 GHz, typically through a surface, structure or body, or portions thereof, to which at least one layer of said composition has been applied.

Embodiments of the invention are described below by way of example only and with reference to the accompanying drawings in which:

Figure 1 shows a Dallenbach absorber;

Figure 2 is a predicted reflectivity spectrum for a coating according to the invention and a prior art coating comprising milled carbon fibres;

Figure 3 is a reflectivity spectrum for a coating according to the invention at two sample orientations (0° and 90°) relative to the electromagnetic field;

Figure 4 is a reflectivity spectrum for a preferred coating according to the invention comprising calcium carbonate, at two sample orientations (0° and 90°) relative to the electromagnetic field;

Figure 5 is a reflectivity spectrum for a coating comprising 1.5 vol% permalloy filler and a coating comprising 2 vol% permalloy filler; and

Figure 6 is a reflectivity spectrum for a hybrid coating comprising 3.5 vol% milled carbon fibres and 1 vol% permalloy flakes, and a prior art coating comprising 5 vol% milled carbon fibres.

Figure 1 is a schematic illustration of a Dallenbach absorber. In an embodiment of the invention, the Dallenbach absorber is a RAM structure comprising an absorbing layer (1) formed from a composition according to the invention and having a depth one quarter of the thickness of the expected radar (or other) wave, and a metallic backing layer (2). Incident electromagnetic radiation (3) impinges on the absorbing layer and undergoes wave cancellation by known principles.

Initial test

Permalloy flakes comprising 81% nickel, 17% iron and 2% molybdenum were tested in paraffin wax dispersions (at about 5 vol% flake), and shown to produce a ferromagnetic resonance frequency of approximately 3 GHz. Hence, the flakes were considered to be suitable candidate materials for the coating composition of the invention.

Predicted RAM response

The results from the initial test were extrapolated and used to predict the performance of a polyurethane-based RAM. Figure 2 compares the reflectivity response of a layer of a magnetic flake based RAM comprising permalloy flakes in polyurethane at 3.5% by volume at a suitable thickness (lower trace) with the reflectivity response of a layer of dielectric RAM comprising milled carbon fibres dispersed in polyurethane at 5.5% by volume, at a suitable thickness (upper trace). The results show that an absorber comprising the composition of the invention can be used to produce an absorber with wider bandwidth than milled carbon fibre (i.e. a wider bandwidth at 10dB).

Table 1 summarises predicted results for four different filler types, specifically a known dielectric filler (milled carbon fibre), two conventional magnetic fillers (magnetite spherical particles and MnZn ferrite spherical particles) and a magnetic filler according to the invention (81% nickel, 17% iron and 2% molybdenum permalloy flake).

Table 1: Predicted absorption results for (A) milled carbon fibre, (B) magnetite spherical particles, (C) MnZn ferrite spherical particles and (D) permalloy flake.

| Filler type | Ferromagnetic Resonance Frequency (GHz) | Loading (vol%) | 3GHz peak absorption (dB) | 10dB bandwidth (GHz) | 15dB bandwidth (GHz) | 20dB bandwidth (GHz) | EM properties at 3GHz |
|---|---|---|---|---|---|---|---|
| (A) | N/A | 5.5 | 22 | 0.4 | 0.2 | 0 | $\varepsilon=35+9i$ $\mu=1+0i$ |
| (B) | 2.5 | 30 | 35 | 1.25 | 0.6 | 0.375 | $\varepsilon=12.9+0.25i$ $\mu=1.35+0.7i$ |
| (C) | 1.5 | 25 | 35 | 1.75 | 0.75 | 0.5 | $\varepsilon=7.5+0.2i$ $\mu=1.3+0.85i$ |
| (D) | 3 | 3.5 | 40 | 1.25 | 0.75 | 0.375 | $\varepsilon=11.15+0.35i$ $\mu=1.15+0.5i$ |

Example 1

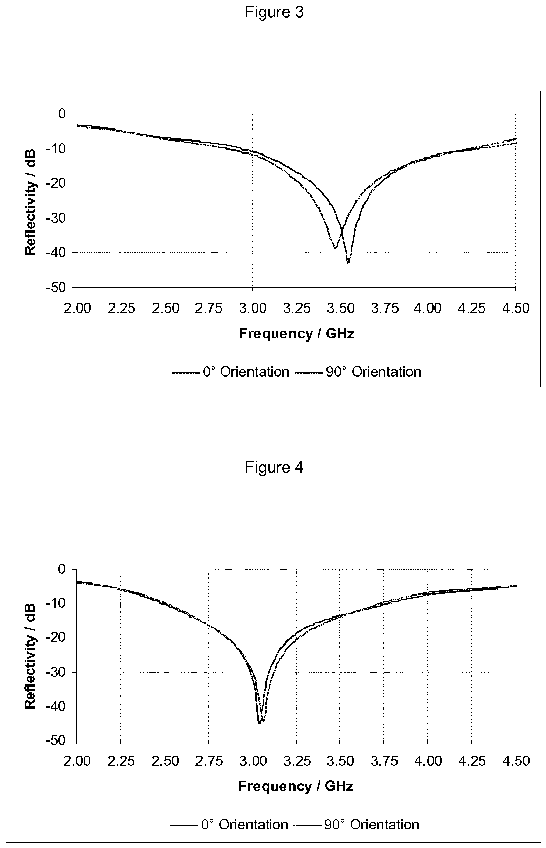

RAM coatings comprising 81% nickel, 17% iron and 2% molybdenum permalloy flake dispersed in polyurethane at 2.25% by volume were manufactured to a suitable thickness using a horizontal casting technique, and tested in the laboratory. As shown by Figure 3, the samples produced an effective absorption bandwidth and magnitude. The results showed no significant directionality between two sample orientations (0° - right hand trace in Figure 3 - and 90° - left hand trace in Figure 3) relative to the electromagnetic field. Although the peak absorption position was higher than required, modelling showed that the performance could be re-tuned to about 3 GHz with a slight increase in coating thickness (<1mm).

Example 2

Scaled up RAM samples were then made using the vertical casting and rotational techniques, the coating composition comprising 81% nickel, 17% iron and 2% molybdenum permalloy flake dispersed in polyurethane at 2.25% by volume, and calcium carbonate (added to reduce overall required thickness and cost) to a suitable thickness. Figure 4 demonstrates the performance of a vertically cast sample consisting of permalloy flakes dispersed in a host matrix of polyurethane with calcium carbonate, at 0° (left hand trace) and 90° (right hand trace) orientations.
The vertical casting technique can lead to a different flake orientation than that produced with horizontal casting, which potentially leads to undesirable directionality within the samples. However, the results show that, for this combination of fillers, there was no significant difference between the different orientations.

Example 3

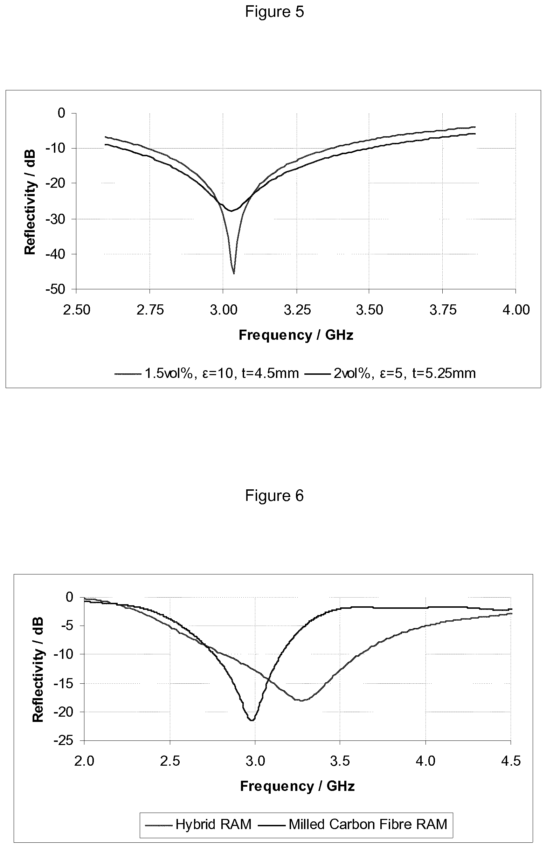

Figure 5 shows the predicted properties of an absorber incorporating a coating comprising 1.5 vol% permalloy filler and a coating comprising 2 vol% permalloy filler, both in a polyurethane matrix, and each provided at appropriate thicknesses for the absorber configuration. It can be seen that, although it is desirable to reduce the magnetic filler loading so as to reduce the cost, the 1.5 vol% sample (upper trace with peak reflectivity in excess of -45 dB) exhibits a lower bandwidth.

Example 4

A hybrid absorber composition was prepared comprising 3.5 vol% milled carbon fibres and 1 vol% permalloy flakes in a polyurethane matrix. Figure 6 shows the performance of the composition when applied at an appropriate thickness (left hand trace) in comparison to milled carbon fibres dispersed in polyurethane at 5.5% by volume, at an appropriate thickness (right hand trace). The composition demonstrates an improved 10dB bandwidth of 0.8 GHz, when compared with the values given in Table 1 for a dielectric absorber (filler type (A)). Hence, although an absorber composed substantially entirely of magnetic flakes may provide the optimum solution in terms of improved bandwidth, a hybrid coating can nevertheless provide useful bandwidth improvement.

**Claims**

1. An electromagnetic radiation absorbing composition comprising a magnetic filler material taking the form of a metallic flake, and a non-conductive binder, wherein the magnetic filler is present in the range of from 1 to 5 volume% of dried volume, and wherein the metallic flake is a permalloy flake, wherein the composition further comprises a dielectric filler material so as to form a hybrid coating, and where the dielectric filler material is milled carbon fibre.

2. An electromagnetic radiation absorbing composition comprising a magnetic filler material taking the form of a metallic flake, and a non-conductive binder, wherein the magnetic filler is present in the range of from 1 to 5 volume% of dried volume, and wherein the metallic flake is a permalloy flake, wherein the permalloy flake comprises 81% nickel, 17% iron and 2% molybdenum.

3. A composition according to any preceding claim, wherein the metallic flake has an average flake size that lies in the range 1 to 100 microns, wherein the metallic flake has an average thickness of less than 4 microns, preferably 0.1 to 3 microns, wherein the metallic flake takes the form of a regular or irregular disc.

4. A composition according to any preceding claim, wherein the metallic flake has a width and a length and the average width to length ratio less than 1:5.

5. A composition according to any preceding claim, wherein the binder is selected from an acrylate binder, an acrylic binder, an epoxy binder, a urethane and/or epoxy-modified acrylic binder, a polyurethane binder, an alkyd based binder, or a fluoropolymer based binder.

6. A composition according to any preceding claim, wherein the binder is selected from a water-based dispersion comprising a binder selected from an acrylic, or polyurethane based latex.

7. A composition according to any preceding claim, wherein the composition is a liquid formulation and optionally comprises a solvent.

8. A composition according to any one of claims 1 to 7, wherein the composition is in the form of a dried coating.

9. A radar absorbing surface, structure or body, or portions thereof, comprising at least one dried coating according to claim 8.

10. A surface, structure or body according to claim 9, wherein the thickness of said coating is one quarter of the wavelength ($\lambda/4$) of the resonant frequency of the incident radiation to be absorbed.

11. A surface, structure or body according to claim 9 or claim 10, wherein there is provided an electromagnetic reflective backplane between the surface, structure or body and the at least one dried coating according to claim 8.

12. A surface, structure or body according to any one of claims 9 to 11, wherein said dried coating forms the exposed topmost layer.

13. An applique film comprising a composition according to any one of claims 1 to 8.

14. The use of a composition according to any one of claims 1 to 8, wherein the composition is applied to a surface, structure or body or portions thereof at a selected thickness so as to provide a coating capable of absorbing electromagnetic radiation at a selected frequency.

15. A method of providing absorption of electromagnetic radiation at a selected frequency on a surface structure or body or portions thereof, comprising the step of determining the selected frequency, applying at least one coat of composition according to any one of claims 1 to 8 at a thickness which selectively absorbs at said frequency, or an applique film according to claim 13 with a thickness which selectively absorbs at said frequency, to a first side of said surface structure or body or portions thereof, and optionally to a second side.

16. The use of a composition according to any one of claims 1 to 8 as a paint composition capable of attenuating electromagnetic radiation in the frequency of 0.1 to 20 GHz, the composition being applied to a surface, structure or body, or portions thereof, as at least one coat.

17. The use of a composition according to any one of claims 1 to 8 to attenuate electromagnetic radiation in the frequency range 0.1 to 20 GHz through a surface, structure or body, or portions thereof, to which at least one layer of said composition has been applied.

**Patentansprüche**

1. Elektromagnetische Strahlung absorbierende Zusammensetzung, umfassend ein magnetisches Füllmaterial, das die Form einer metallischen Flocke annimmt, und ein nichtleitendes Bindemittel, wobei das magnetische Füllmaterial im Bereich von 1 bis 5 Vol.-% getrocknetes Volumen vorliegt und wobei die metallische Flocke eine Permalloy-Flocke ist, wobei die Zusammensetzung ferner ein dielektrisches Füllmaterial umfasst, um eine Hybridbeschichtung zu bilden, und wobei das dielektrische Füllmaterial gemahlene Kohlenstofffasern ist.

2. Elektromagnetische Strahlung absorbierende Zusammensetzung, umfassend ein magnetisches Füllmaterial, das die Form einer metallischen Flocke annimmt, und ein nichtleitendes Bindemittel, wobei das magnetische Füllmaterial im Bereich von 1 bis 5 Vol.-% getrocknetes Volumen vorliegt und
wobei die metallische Flocke eine Permalloy-Flocke ist,
wobei die Permalloy-Flocke 81% Nickel, 17% Eisen und 2% Molybdän umfasst.

3.  Zusammensetzung nach einem der vorhergehenden Ansprüche, wobei die metallische Flocke eine durchschnittliche Flockengröße aufweist, die im Bereich von 1 bis 100 Mikrometer liegt, wobei die metallische Flocke eine durchschnittliche Dicke von weniger als 4 Mikrometer, vorzugsweise 0,1 bis 3 Mikrometer aufweist, wobei die metallische Flocke die Form einer regelmäßigen oder unregelmäßigen Scheibe annimmt.

4.  Zusammensetzung nach einem der vorhergehenden Ansprüche, wobei die metallische Flocke eine Breite und eine Länge und das durchschnittliche Verhältnis von Breite zu Länge von weniger als 1:5 aufweist.

5.  Zusammensetzung nach einem der vorhergehenden Ansprüche, wobei das Bindemittel aus einem Acrylatbindemittel, einem Acrylbindemittel, einem Epoxidbindemittel, einem Urethan- und/oder epoxidmodifizierten Acrylbindemittel, einem Polyurethanbindemittel, einem Bindemittel auf Alkydbasis oder einem Bindemittel auf Fluorpolymerbasis ausgewählt ist.

6.  Zusammensetzung nach einem der vorhergehenden Ansprüche, wobei das Bindemittel aus einer wasserbasierten Dispersion ausgewählt ist, die ein Bindemittel umfasst, das aus einem acryl- oder polyurethanbasierten Latex ausgewählt ist.

7.  Zusammensetzung nach einem der vorhergehenden Ansprüche, wobei die Zusammensetzung eine flüssige Formulierung ist und optional ein Lösungsmittel umfasst.

8.  Zusammensetzung nach einem der Ansprüche 1 bis 7, wobei die Zusammensetzung in Form einer getrockneten Beschichtung vorliegt.

9.  Radarabsorbierende Oberfläche, Struktur oder radarabsorbierender Körper, oder Teile davon, umfassend mindestens eine getrocknete Beschichtung nach Anspruch 8.

10. Oberfläche, Struktur oder Körper nach Anspruch 9, wobei die Dicke der Beschichtung ein Viertel der Wellenlänge ($\lambda/4$) der Resonanzfrequenz der einfallenden zu absorbierenden Strahlung beträgt.

11. Oberfläche, Struktur oder Körper nach Anspruch 9 oder Anspruch 10, wobei zwischen der Oberfläche, Struktur oder dem Körper und der mindestens einen getrockneten Beschichtung nach Anspruch 8 eine elektromagnetisch reflektierende Rückwand bereitgestellt ist.

12. Oberfläche, Struktur oder Körper nach einem der Ansprüche 9 bis 11, wobei die getrocknete Beschichtung die freiliegende oberste Schicht bildet.

13. Applikationsfilm, umfassend eine Zusammensetzung nach einem der Ansprüche 1 bis 8.

14. Verwendung einer Zusammensetzung nach einem der Ansprüche 1 bis 8, wobei die Zusammensetzung auf eine Oberfläche, Struktur oder einen Körper oder Teile davon in einer ausgewählten Dicke aufgebracht wird, um eine Beschichtung bereitzustellen, die in der Lage ist, elektromagnetische Strahlung mit einer ausgewählten Frequenz zu absorbieren.

15. Verfahren zum Bereitstellen einer Absorption von elektromagnetischer Strahlung mit einer ausgewählten Frequenz auf einer Oberflächenstruktur oder einem Körper oder Teilen davon, umfassend den Schritt des Bestimmens der ausgewählten Frequenz, Aufbringen von mindestens einer Schicht aus der Zusammensetzung nach einem der Ansprüche 1 bis 8
bei einer Dicke, die selektiv bei der Frequenz absorbiert, oder
eines Applikationsfilms nach Anspruch 13 mit einer Dicke, die selektiv bei der Frequenz absorbiert, auf eine erste Seite der Oberflächenstruktur oder des Körpers oder Teilen davon und optional auf eine zweite Seite.

16. Verwendung einer Zusammensetzung nach einem der Ansprüche 1 bis 8 als Farbzusammensetzung, die in der Lage ist, elektromagnetische Strahlung in der Frequenz von 0,1 bis 20 GHz abzuschwächen, wobei die Zusammensetzung auf eine Oberfläche, Struktur oder einen Körper, oder Teile davon, als mindestens eine Schicht aufgebracht wird.

17. Verwendung einer Zusammensetzung nach einem der Ansprüche 1 bis 8 zur Dämpfung elektromagnetischer Strahlung im Frequenzbereich von 0,1 bis 20 GHz durch eine Oberfläche, Struktur oder einen Körper, oder Teile davon, auf die mindestens eine Schicht der Zusammensetzung aufgebracht wurde.

**Revendications**

1. Composition absorbant le rayonnement électromagnétique, comprenant un matériau de remplissage magnétique se présentant sous forme d'une paillette métallique, et un liant non conducteur, le matériau de remplissage magnétique étant présent dans une plage allant de 1 à 5 % en volume sec, et la paillette métallique étant une paillette en permalloy, la composition comprenant en outre un matériau de remplissage diélectrique de façon à former un revêtement hybride, et le matériau de remplissage diélectrique étant une fibre de carbone broyée.

2. Composition absorbant le rayonnement électromagnétique, comprenant un matériau de remplissage magnétique se présentant sous forme d'une paillette métallique, et un liant non conducteur, le matériau de remplissage magnétique étant présent dans une plage allant de 1 à 5 % en volume sec, et la paillette métallique étant une paillette en permalloy,
   la paillette en permalloy comprenant 81 % de nickel, 17 % de fer et 2 % de molybdène.

3. Composition selon une quelconque des revendications précédentes, la taille moyenne de paillette de la paillette métallique étant comprise dans la plage allant de 1 à 100 microns, l'épaisseur moyenne de paillette de la paillette métallique étant inférieure à 4 microns, et étant comprise de préférence entre 0,1 et 3 microns, la paillette métallique ayant la forme d'un disque régulier ou irrégulier.

4. Composition selon une quelconque des revendications précédentes, la paillette métallique ayant une largeur et une longueur, et un rapport largeur / longueur inférieur à 1/5.

5. Composition selon une quelconque des revendications précédentes, le liant étant sélectionné parmi les suivants : un liant en acrylate, un liant en acrylique, un liant époxy, un liant en uréthane et/ou en acrylique modifié par époxy, un liant en polyuréthane, un liant à base d'alkyde, ou un liant à base de fluoropolymère.

6. Composition selon une quelconque des revendications précédentes, le liant étant sélectionné dans une dispersion à base d'eau comprenant un liant sélectionné parmi un latex acrylique ou à base de polyuréthane.

7. Composition selon une quelconque des revendications précédentes, la composition étant une formulation liquide et, en option, comprenant un solvant.

8. Composition selon une quelconque des revendications 1 à 7, la composition se présentant sous forme d'un revêtement séché.

9. Surface, structure ou corps, ou portions de ces derniers, absorbant les ondes radar, comprenant au moins un revêtement séché selon la revendication 8.

10. Surface, structure ou corps selon la revendication 9, l'épaisseur dudit revêtement étant un quart de la longueur d'onde ($\lambda$/4) de la fréquence résonante du rayonnement incident devant être absorbé.

11. Surface, structure ou corps selon la revendication 9 ou la revendication 10, comportant une face arrière réfléchissante électromagnétique entre la surface, la structure ou le corps, et l'au moins un revêtement séché selon la revendication 8.

12. Surface, structure ou corps selon une quelconque des revendications 9 à 11, ledit revêtement séché formant la couche supérieure exposée.

13. Film d'applique comprenant une composition selon une quelconque des revendications 1 à 8.

14. Utilisation d'une composition selon une quelconque des revendications 1 à 8, la composition étant appliquée sur une surface, une structure ou un corps, ou des parties de ces derniers, à une épaisseur sélectionnée, de façon à former un revêtement capable d'absorber un rayonnement électromagnétique à une fréquence sélectionnée.

15. Méthode de réalisation d'une absorption d'un rayonnement électromagnétique à une fréquence sélectionnée sur une surface, une structure ou un corps, ou des parties de ces derniers, comprenant l'étape de détermination de la fréquence sélectionnée, en appliquant au moins une couche d'une composition selon une quelconque des revendications 1 à 8 à une fréquence absorbant de façon sélective à ladite fréquence, ou

un film d'applique selon la revendication 13, avec une épaisseur absorbant de façon sélective à ladite fréquence, sur un premier côté desdits surface, structure ou corps, ou des parties de ces derniers, et, en option, sur un deuxième côté.

16. Utilisation d'une composition selon une quelconque des revendications 1 à 8, en tant que composition de peinture capable d'atténuer un rayonnement électromagnétique dans la fréquence allant de 0,1 à 20 GHz, la composition étant appliquée sur une surface, une structure ou un corps, ou des parties de ces derniers, en tant qu'au moins une couche.

17. Utilisation d'une composition selon une quelconque des revendications 1 à 8, pour atténuer le rayonnement électromagnétique dans la plage de fréquences allant de 0,1 à 20 GHz à travers une surface, une structure ou un corps, ou des parties de ces derniers, sur lesquels au moins une couche de ladite composition a été appliquée.

Figure 1

Figure 2

Figure 3

Figure 4

Figure 5

Figure 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010109174 A
- US 7897882 B
- WO 03098989 A
- US 2009226673 A
- WO 2009095654 A